# EUROPEAN PATENT APPLICATION

(11) **EP 3 758 065 A1**
(43) Date of publication of application: **30.12.2020**
(21) Application number: 19917826.0
(22) Date of filing: 06.03.2019
(51) Int. Cl.: H01L 23/64, H01L 21/02

(54) **SEMICONDUCTOR STRUCTURE AND MANUFACTURE METHOD THEREFOR**

(71) Applicant: SHENZHEN GOODIX TECHNOLOGY CO., LTD., Shenzhen, Guangdong 518045 (CN)
(72) Inventor: LU, Bin, Shenzhen, Guangdong 518045 (CN); SHEN, Jian, Shenzhen, Guangdong 518045 (CN)
(74) Representative: Pfenning, Meinig & Partner mbB
(86) International application number: PCT/CN2019/077180
(87) International publication number: WO 2020/177098

(57) **Abstract**

The present application provides a semiconductor structure and a production method thereof so that a non-linear trench structure can be produced, which can increase a surface area of the trench structure without increasing an aspect ratio and maintaining the same footprint. The semiconductor structure includes: a substrate including an upper surface and a lower surface disposed opposite to each other; and at least one trench structure disposed in the substrate and formed downward from the upper surface, where the trench structure is projected on the upper surface to form a first pattern in a curved or broken line shape, and the first pattern includes n second patterns adjacent to each other, and in the n second patterns, odd-numbered second patterns are the same, and even-numbered second patterns are the same, where n is a positive integer.

## Description

### TECHNICAL FIELD

The present application relates to the field of semiconductors, and more particularly, to a semiconductor structure and a production method thereof.

### BACKGROUND

As an energy storage device (for example, a battery, a capacitor, etc.), a sensor, or the like are widely used in modern electronic systems, it is necessary to produce a structure with a high surface area and a low footprint to increase an energy density and a sensing area.

Using plasma etching technology to produce a trench with a high aspect ratio on a substrate is a widely used method to increase a surface area. However, due to the characteristics of plasma etching technology, processing a structure with a high aspect ratio has greater process difficulty. To put it simply, as etching progresses to a certain depth, on the one hand, it is difficult for a reactive substance participating in the etching to continue to enter the bottom of a trench, and on the other hand, it is difficult for a product generated in the reaction to diffuse out from the bottom of the trench. The smaller the trench opening is, the greater the trench depth is, and the more serious this phenomenon is. Therefore, using the existing etching technology to produce a structure with a higher aspect ratio easily leads to process problems such as low etching efficiency, poor etching uniformity, and poor repeatability. In addition, apart from the above-mentioned problems of the etching itself, the difficulty of performing subsequent processes on the structure with a higher aspect ratio is correspondingly increased. The resulting series of problems such as yield, output, and costs are difficult to be solved. Therefore, how to produce a structure with a high surface area and a low footprint is an urgent technical problem to be solved.

### SUMMARY

The present application provides a semiconductor structure and a production method thereof so that a non-linear trench structure can be produced, which can increase a surface area of the trench structure without increasing an aspect ratio and maintaining the same footprint.

According to a first aspect, provided is a semiconductor structure, including:
a substrate including an upper surface and a lower surface disposed opposite to each other; and
at least one trench structure disposed in the substrate and formed downward from the upper surface,
where the trench structure is projected on the upper surface to form a first pattern in a curved or broken line shape, and the first pattern includes n second patterns adjacent to each other, and in the n second patterns, odd-numbered second patterns are the same, and even-numbered second patterns are the same, where n is a positive integer.

Therefore, in the semiconductor structure provided by the embodiment of the present application, compared to a linear trench structure, the at least one trench structure in the curved or broken line shape disposed in the substrate can increase a surface area of the trench structure without increasing an aspect ratio and maintaining the same footprint.

In some possible implementation manners, the odd-numbered second pattern is rotatable to obtain the even-numbered second pattern, or the even-numbered second pattern is rotatable to obtain the odd-numbered second pattern.

In some possible implementation manners, the semiconductor structure is used to produce a structure with a high surface area and a low footprint.

In some possible implementation manners, the semiconductor structure is used to produce an energy storage device and/or a sensor, where the energy storage device and/or the sensor includes at least one conductive layer and at least one dielectric layer in the trench structure.

Therefore, when the semiconductor structure of the embodiment of the present application is applied to an energy storage device and/or a sensor, an energy density of the energy storage device and a sensing area of the sensor can be increased.

In a second aspect, provided is a semiconductor structure production method, including:
providing a substrate including an upper surface and a lower surface disposed opposite to each other; and
etching at least one trench structure on the substrate based on a first pattern in a curved or broken line shape, the trench structure entering the substrate downward from the upper surface, where the first pattern includes n second patterns adjacent to each other, and in the n second patterns, odd-numbered second patterns are the same, and even-numbered second patterns are the same, where n is a positive integer.

Therefore, in the embodiment of the present application, the trench structure in the curved or broken line shape can be etched on the substrate based on the first pattern in the curved or broken line shape, which can increase a surface area of the trench structure without increasing an aspect ratio and maintaining the same footprint.

In some possible implementation manners, before the etching the at least one trench structure, the method further includes:
providing a linear trench pattern with a length of L and a width of W, where L and W are positive numbers;
dividing the linear trench pattern into n rectangular patterns adjacent to each other, where the rectangular pattern has a first long side and a second long side with a length of L/n in a first direction, and the rectangular pattern has two wide sides with a width of W in a second direction, and the first direction is perpendicular to the second direction;
dividing an odd-numbered rectangular pattern in the n rectangular patterns into two first sub-patterns according to a first dividing line, where the two first sub-patterns include the first long side and the second long side respectively, and the first dividing line connects two end points of the first long side;
overlapping the long sides of the two first sub-patterns to form N1 first basic patterns, where N1 is a positive integer;
dividing an even-numbered rectangular pattern in the n rectangular patterns into two second sub-patterns according to a second dividing line, where the two second sub-patterns include the first long side and the second long side respectively, and the second dividing line connects two end points of the second long side;
overlapping the long sides of the two second sub-patterns to form N2 second basic patterns, where N2 is a positive integer; and
combining the N1 first basic patterns and the N2 second basic patterns to form the first pattern, where the sum of N1 and N2 is n.

It should be noted that the area of the first pattern is exactly the same as that of the original linear trench pattern, and therefore the footprint remains unchanged. The perimeter of the first pattern is greater than that of the linear trench pattern, and perimeter multiplied depth equals surface area, and thus the surface area is increased.

In some possible implementation manners, before the etching the at least one trench structure, the method further includes:
removing sharp corners at head and tail ends of the first pattern.

It should be noted that by removing the sharp corners at the head and tail ends of the first pattern, when the first pattern is used to produce a device (for example, an energy storage device), it is possible to avoid the formation of an area where an electric field is too concentrated at the sharp corners, thereby ensuring the performance of the produced device.

In some possible implementation manners, the removing the sharp corners at the head and tail ends of the first pattern includes:
removing sharp corners less than 90 degrees at the head and tail ends of the first pattern.

In some possible implementation manners, the first dividing line and/or the second dividing line is at least one curve and/or at least one broken line.

In some possible implementation manners, the first dividing line and the second dividing line are symmetrical with an axis of the linear trench pattern being a symmetry axis.

In some possible implementation manners, the first basic pattern is rotatable to obtain the second basic pattern, or the second basic pattern is rotatable to obtain the first basic pattern.

In some possible implementation manners, the etching the at least one trench structure on the substrate based on the first pattern in the curved or broken line shape includes:
etching the at least one trench structure on the substrate by deep reactive ion etching (deep reactive ion etching, DRIE) based on the first pattern.

### BRIEF DESCRIPTION OF THE DRAWINGS

FIG. 1 and FIG. 2 show schematic diagrams of a semiconductor structure 100 according to an embodiment of the present application.
FIG. 3 is a schematic diagram of a first pattern 121 according to an embodiment of the present application.
FIG. 4 is a schematic diagram of a semiconductor structure 100 according to an embodiment of the present application.
FIG. 5 shows a schematic flow chart of a semiconductor structure production method 200 according to an embodiment of the present application.
FIG. 6 is a schematic diagram of a semiconductor structure production method according to an embodiment of the present application.
FIG. 7 is a schematic diagram of another semiconductor structure production method according to an embodiment of the present application.
FIG. 8 is a schematic diagram of another semiconductor structure production method according to an embodiment of the present application.
FIG. 9 is a schematic diagram of yet another semiconductor structure production method according to an embodiment of the present application.
FIG. 10 is a schematic diagram of yet another semiconductor structure production method according to an embodiment of the present application.
FIG. 11 is a schematic diagram of yet another semiconductor structure production method according to an embodiment of the present application.

### DESCRIPTION OF EMBODIMENTS

Technical solutions in embodiments of the present application will be described hereinafter in conjunction with the accompanying drawings.

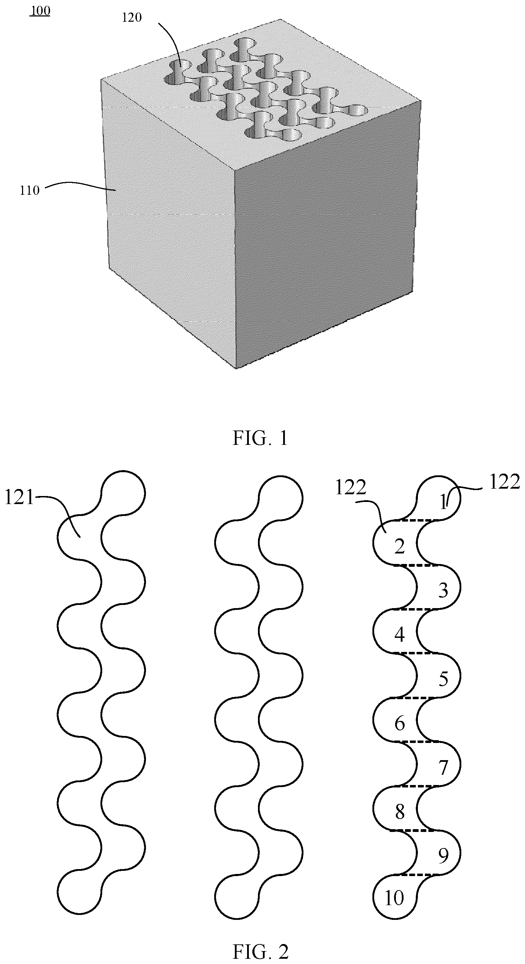

FIG. 1 and FIG. 2 show schematic diagrams of a semiconductor structure 100 according to an embodiment of the present application.

FIG. 1 is a three-dimensional view of a semiconductor structure 100, and FIG. 2 is a first pattern 121 formed by projection of at least one trench structure 120 in the semiconductor structure 100 on an upper surface of a substrate 110.

As shown in FIG. 1, the semiconductor structure 100 includes a substrate 110 and at least one trench structure 120.

The substrate 110 includes an upper surface and a lower surface disposed opposite to each other.

The at least one trench structure 120 is disposed in the substrate 110 and formed downward from the upper surface.

As shown in FIG. 2, the trench structure 120 is projected on the upper surface to form a first pattern 121 in a curved or broken line shape, and the first pattern 121 includes n second patterns 122 adjacent to each other, and in the n second patterns 122, odd-numbered second patterns 122 are the same, and even-numbered second patterns 122 are the same, where n is a positive integer.

That is, in the embodiment of the present application, the trench structure 120 is a non-linear trench.

Specifically, as shown in FIG. 2, n is 10, second patterns 122 numbered 1, 3, 5, 7 and 9 (odd digits) are the same, and second patterns 122 numbered 2, 4, 6, 8 and 10 (even digits) are the same. It should be noted that the serial numbers of the second patterns 122 are assigned for a better understanding of the solution, and the present application is not limited thereto.

It should be noted that sharp corners are removed from the second pattern 122 numbered 1 and the second pattern 122 numbered 10. By removing the sharp corners at head and tail ends of the trench structure 120, when the trench structure 120 is used to produce a device (for example, an energy storage device), it is possible to avoid the formation of an area where an electric field is too concentrated at the sharp corners, thereby ensuring the performance of the produced device.

Of course, in the embodiment of the present application, it is also not necessary to remove the sharp corners at head and tail ends of the trench structure 120.

Optionally, the odd-numbered second pattern 122 is rotatable to obtain the even-numbered second pattern 122, or the even-numbered second pattern 122 is rotatable to obtain the odd-numbered second pattern 122. For example, as shown in FIG. 2, the second pattern 122 numbered 2 is rotatable to obtain the second pattern 122 numbered 3, and of course, the second pattern 122 numbered 3 is rotatable to obtain the second pattern 122 numbered 2.

Optionally, in the embodiment of the present application, first patterns 121 in different trench structures 120 among the at least one trench structure 120 may be the same or different.

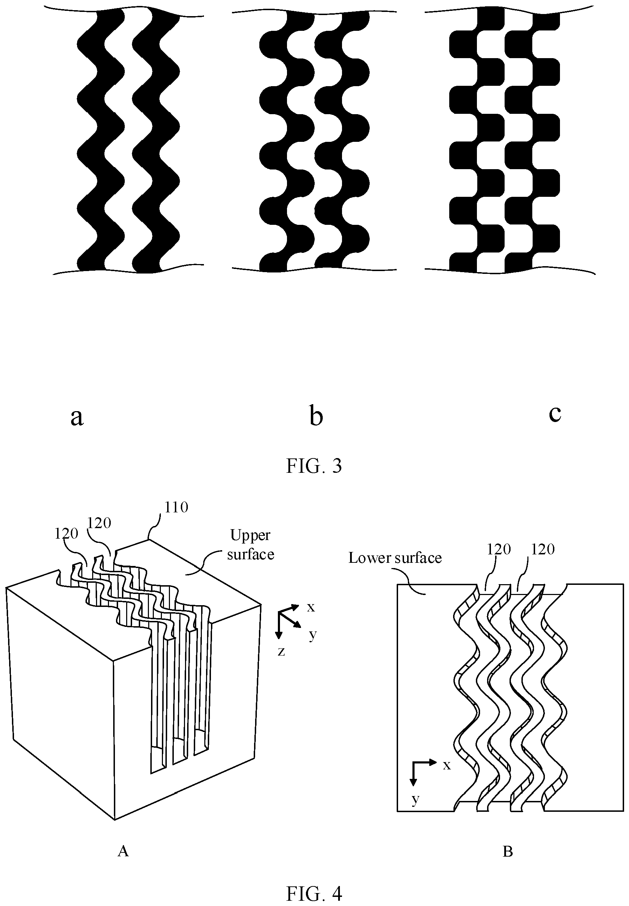

For example, the first pattern 121 may be one or more of three patterns a, b, and c shown in FIG. 3. Of course, the first pattern 121 may also be other regular or irregular patterns, which is not limited in the present application.

Optionally, in the embodiment of the present application, the semiconductor structure 100 may be as shown in FIG. 4 in which A is a perspective view of at least one trench structure 120 in the semiconductor structure 100 according to the embodiment of the present application, and B is a top view of at least one trench structure 120 in the semiconductor structure 100 according to the embodiment of the application. And in FIG. 4, x direction represents a width direction of the trench 120, y direction represents a length direction of the trench 120, and z direction represents a depth direction of the trench 120. The semiconductor structure 100 shown in FIG. 4 includes three trench structures 120, and the three trench structures 120 are disposed in the substrate 110 and formed downward from an upper surface of the substrate 110. The trench structure 120 is projected on the upper surface of the substrate 110 to form a first pattern 121 in a curved line shape.

Optionally, in the embodiment of the present application, the semiconductor structure 100 is applied to a structure with a high surface area and a low footprint. For example, based on the non-linear first pattern 121, at least one trench structure 120 is etched on the substrate 110 by deep reactive ion etching, which can increase a surface area of the trench structure 120 without increasing an aspect ratio and maintaining the same footprint, for example, increasing the surface area by more than 50%.

Optionally, the semiconductor structure 100 is used to produce an energy storage device and/or a sensor, where the energy storage device and/or the sensor includes at least one conductive layer and at least one dielectric layer in the trench structure 120, and the at least one conductive layer and the at least one dielectric layer form a structure in which the conductive layer and the dielectric layer are adjacent to each other.

For example, a dielectric layer and a conductive layer are alternately deposited in the trench structure 120 to form an energy storage device.

Optionally, as an example, a dielectric layer and a conductive layer are alternately deposited in the trench structure 120 to form a capacitor.

It should be noted that, in this example, the dielectric layer deposited in the trench structure 120 may include at least one of: a silicon dioxide layer, a silicon nitride layer, an aluminum oxide (Al₂O₃) layer, a zirconium oxide (ZrO₂) layer, a hafnium oxide (HfO₂) layer, a titanium oxide (TiO₂) layer, a yttrium oxide (Y₂O₃) layer, a lanthanum oxide (La₂O₃) layer, a hafnium silicate (HfSiO₄) layer, a lanthanum aluminate (LaAlO₃) layer, a lanthanum lutetium oxide (LaLuO₃) layer, a barium titanate (BaTiO₃) layer, a strontium titanate (SrTiO₃) layer, a barium strontium titanate (BaₓSr₁₋ₓTiO₃, BST) layer, a lead zirconate titanate (PbZrₓTi₁₋ₓO₃, PZT) layer, and a calcium copper titanate (CaCu₃Ti₄O₁₂, CCTO) layer. A specific insulating material and a dielectric layer thickness may be adjusted according to a capacitance value, a frequency characteristic, a loss and other requirements of a capacitor. Of course, the dielectric layer may further include some other material layers having high dielectric constant characteristics, which is not limited in the embodiment of the present application. The conductive layer deposited in the trench structure 120 includes at least one of: a heavily doped polysilicon layer, a carbon-based material layer, a metal layer, and a titanium nitride layer. A specific conductive material may be heavily doped polysilicon, a carbon-based material, or various metals such as aluminum, tungsten and copper, and may also be a low resistivity compound such as titanium nitride (TiN) and tantalum nitride (TaN), or a combination of the above several conductive materials.

The dielectric layer deposited in the trench structure 120 may be a stack of silicon dioxide/aluminum oxide/silicon dioxide (SiO₂/Al₂O₃/SiO₂) containing a material with high dielectric constant, so that capacitance density can be improved.

Optionally, in the embodiment of the present application, the substrate 110 may be an n-type or p-type heavily doped low-resistivity silicon wafer. A high-resistivity wafer may also be adopted, but after the trench structure 120 is produced, the upper surface (front side) of the substrate 110 and a surface of the trench structure 120 are required to be doped to form a heavily doped low-resistivity conductive layer.

Therefore, in the semiconductor structure provided by the embodiment of the present application, the at least one trench structure disposed in the substrate is a trench structure in a curved or broken line shape. Compared with a linear trench structure, the trench structure in the curved or broken line shape can increase a surface area of the trench structure without increasing an aspect ratio and maintaining the same footprint.

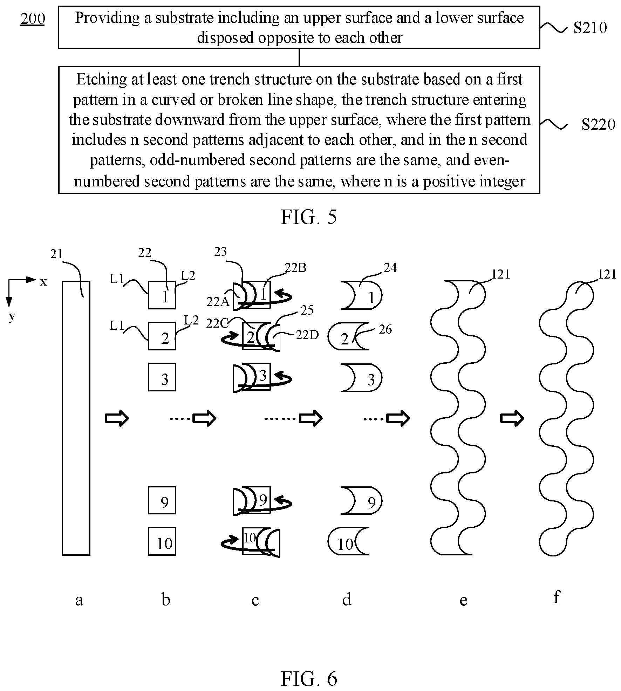

Hereinafter, a semiconductor structure production method according to an embodiment of the present application will be introduced in detail with reference to FIGS. 5 to 11.

It should be understood that FIG. 5 is a schematic flow chart of a semiconductor structure production method according to an embodiment of the present application, but these steps or operations are merely examples, and other operations or variations of various operations in FIG. 5 may also be performed in the embodiment of the present application.

FIG. 5 shows a schematic flow chart of a semiconductor structure production method 200 according to an embodiment of the present application. As shown in FIG. 5, the semiconductor structure production method 200 includes:
S210, providing a substrate including an upper surface and a lower surface disposed opposite to each other; and
S220, etching at least one trench structure on the substrate based on a first pattern in a curved or broken line shape, the trench structure entering the substrate downward from the upper surface, where the first pattern includes n second patterns adjacent to each other, and in the n second patterns, odd-numbered second patterns are the same, and even-numbered second patterns are the same, where n is a positive integer.

Specifically, at least one trench structure 120 is etched on a substrate 110 based on a first pattern 121 in a curved or broken line shape to produce the semiconductor structure 100 as shown in FIG. 1.

Optionally, before the etching the at least one trench structure, the method 200 further includes:
preparing the first pattern.

Specifically, the first pattern can be prepared through the following steps.

Step 1, a linear trench pattern with a length of L and a width of W is provided, where L and W are positive numbers.

Specifically, as shown in a in FIG. 6, a linear trench pattern 21 has a certain length L and width W, where x direction may be a width direction of the linear trench pattern 21, and y direction may be a length direction of the linear trench pattern 21.

Step 2, the linear trench pattern is divided into n rectangular patterns adjacent to each other, n is a positive integer, where the rectangular pattern has a first long side and a second long side with a length of L/n in a first direction, and the rectangular pattern has two wide sides with a width of W in a second direction, and the first direction is perpendicular to the second direction.

Specifically, the linear trench pattern 21 as shown in a in FIG. 6 is divided into ten rectangular patterns 22 adjacent to each other, as shown in b in FIG. 6, and the rectangular pattern 22 includes a first long side S1 and a second long side S2 along the y direction, the lengths of the first long side S1 and the second long side S2 are L/n, and the rectangular pattern 22 has two wide sides with a width of W along the x direction, that is, the first direction is the y direction, and the second direction is the x direction. As shown in b in FIG. 6, the ten rectangular patterns 22 are numbered in the order in which the ten rectangular patterns 22 are formed, and denoted as 1 to 10, respectively.

It should be noted that the first long side S1 and the second long side S2 are formed by two end points and a straight line connecting the two end points.

It should be understood that the specific number of the divided rectangular patterns 22 adjacent to each other may be determined according to actual requirements, for example, it may be determined according to the length L of the linear trench pattern 21.

Assuming that the length L and the width W of the linear trench pattern 21 are 10 µm and 0.8 µm, respectively, the linear trench pattern 21 is divided into ten rectangular patterns 22 of 1 µm × 0.8 µm.

Step 3, an odd-numbered rectangular pattern in the n rectangular patterns is divided into two first sub-patterns according to a first dividing line, where the two first sub-patterns include the first long side and the second long side respectively, and the first dividing line connects two end points of the first long side.

Specifically, an odd-numbered rectangular pattern 22 (numbered 1, 3, 5, 7 and 9) in the ten rectangular patterns 22 shown in b in FIG. 6 is divided into a first sub-pattern 22A and a first sub-pattern 22B according to a first dividing line 23. The first sub-pattern 22A includes the first long side S1, the first sub-pattern 22B includes the second long side S2, and the first dividing line 23 connects two end points of the first long side S1, as shown in c in FIG. 6.

Step 4, the long sides of the two first sub-patterns are overlapped to form N1 first basic patterns, where N1 is a positive integer.

Specifically, the first long side S1 included in the first sub-pattern 22A and the second long side S2 included in the first sub-pattern 22B as shown in c in FIG. 6 are overlapped to form five first basic patterns 24, that is, N1=5, as shown in d in FIG. 6.

Step 5, an even-numbered rectangular pattern in the n rectangular patterns is divided into two second sub-patterns according to a second dividing line, where the two second sub-patterns include the first long side and the second long side respectively, and the second dividing line connects two end points of the second long side.

Specifically, an even-numbered rectangular pattern 22 (numbered 2, 4, 6, 8 and 10) in the ten rectangular patterns 22 shown in b in FIG. 6 is divided into a second sub-pattern 22C and a second sub-pattern 22D according to a second dividing line 25. The second sub-pattern 22C includes the first long side S1, the second sub-pattern 22D includes the second long side S2, and the second dividing line 25 connects two end points of the second long side S2, as shown in c in FIG. 6.

Step 6, the long sides of the two second sub-patterns are overlapped to form N2 second basic patterns, where N2 is a positive integer.

Specifically, the first long side S1 included in the second sub-pattern 22C and the second long side S2 included in the second sub-pattern 22D as shown in c in FIG. 6 are overlapped to form five second basic patterns 26, that is, N2=5, as shown in d in FIG. 6.

Step 7, the N1 first basic patterns and the N2 second basic patterns are combined to form the first pattern 121, where the sum of N1 and N2 is n.

Optionally, the N1 first basic patterns and the N2 second basic patterns are alternately combined. That is, a first basic pattern can only be combined with a second basic pattern, but cannot be combined with another first basic pattern. Similarly, a second basic pattern can only be combined with a first basic pattern, but cannot be combined with another second basic pattern.

Specifically, the five first basic patterns 24 and the five second basic patterns 26 shown in d in FIG. 6 are combined to form the first pattern 121, as shown in e in FIG. 6.

Optionally, the five first basic patterns 24 and the five second basic patterns 26 may be randomly combined.

For example, the first basic pattern 24 numbered 1 is combined with the second basic pattern 26 numbered 6, the second basic pattern 26 numbered 6 is combined with the first basic pattern 24 numbered 3, the first basic pattern 24 numbered 3 is combined with the second basic pattern 26 numbered 2, the second basic pattern 26 numbered 2 is combined with the first basic pattern 24 numbered 5, the first basic pattern 24 numbered 5 is combined with the second basic pattern 26 numbered 8, the second basic pattern 26 numbered 8 is combined with the first basic pattern 24 numbered 7, the first basic pattern 24 numbered 7 is combined with the second basic pattern 26 numbered 10, the second basic pattern 26 numbered 10 is combined with the first basic pattern 24 numbered 9, or the first basic pattern 24 numbered 9 is combined with the second basic pattern 26 numbered 4.

Optionally, the five first basic patterns 24 and the five second basic patterns 26 may be combined in a certain order.

For example, the first basic pattern 24 numbered 1 is combined with the second basic pattern 26 numbered 2, the second basic pattern 26 numbered 2 is combined with the first basic pattern 24 numbered 3, the first basic pattern 24 numbered 3 is combined with the second basic pattern 26 numbered 4, the second basic pattern 26 numbered 4 is combined with the first basic pattern 24 numbered 5, the first basic pattern 24 numbered 5 is combined with the second basic pattern 26 numbered 6, the second basic pattern 26 numbered 6 is combined with the first basic pattern 24 numbered 7, the first basic pattern 24 numbered 7 is combined with the second basic pattern 26 numbered 8, the second basic pattern 26 numbered 8 is combined with the first basic pattern 24 numbered 9, or the first basic pattern 24 numbered 9 is combined with the second basic pattern 26 numbered 10.

It should be understood that the serial number of the first basic pattern 24 is the serial number of the corresponding rectangular pattern 22. For example, the rectangular pattern 22 numbered 1 is divided and combined to form the first basic pattern 24 numbered 1, the rectangular pattern 22 numbered 3 is divided and combined to form the first basic pattern 24 numbered 3, the rectangular pattern 22 numbered 5 is divided and combined to form the first basic pattern 24 numbered 5, the rectangular pattern 22 numbered 7 is divided and combined to form the first basic pattern 24 numbered 7, and the rectangular pattern 22 numbered 9 is divided and combined to form the first basic pattern 24 numbered 9. Similarly, the serial number of the second basic pattern 26 is the serial number of the corresponding rectangular pattern 22. For example, the rectangular pattern 22 numbered 2 is divided and combined to form the second basic pattern 26 numbered 2, the rectangular pattern 22 numbered 4 is divided and combined to form the second basic pattern 26 numbered 4, the rectangular pattern 22 numbered 6 is divided and combined to form the second basic pattern 26 numbered 6, the rectangular pattern 22 numbered 8 is divided and combined to form the second basic pattern 26 numbered 8, and the rectangular pattern 22 numbered 10 is divided and combined to form the second basic pattern 26 numbered 10.

It should be noted that the first basic pattern 24 and the second basic pattern 26 may be combined along the side in the x direction.

Optionally, the at least one trench structure 120 may be etched on the substrate 110 by deep reactive ion etching based on the first pattern 121.

Specifically, first, a layer of photoresist is spin-coated on the upper surface (front side) of the substrate 110 based on the first pattern 121, and after exposure and development, an etched pattern window not covered with the photoresist is formed. Next, at least one trench structure 120 is produced in the substrate 110 by deep reactive ion etching. The trench structure 120 extends downward from the upper surface of the substrate 110, and a depth of the trench structure 120 is less than a thickness of the substrate 110.

It should be understood that after etching the at least one trench structure 120, the photoresist is removed.

It should be noted that the execution orders of the above steps 3 and 4 can be interchanged with those of the above steps 5 and 6, that is, the odd-numbered rectangular patterns can be processed first to form the N1 first basic patterns, or the even-numbered rectangular patterns can also be processed first to form the N2 second basic patterns.

In the semiconductor structure production method 200 described above, the area of the first pattern 121 is exactly the same as that of the original linear trench pattern 21, and therefore the footprint remains unchanged. The perimeter of the first pattern 121 is greater than that of the linear trench pattern 21, and perimeter multiplied by depth equals surface area, and thus the surface area is increased. For example, the perimeter of the first pattern 121 is approximately 1.57 times that of the linear trench pattern 21, and thus the resulting surface area of the trench structure 120 can also be increased by 57%.

Therefore, in the embodiment of the present application, a non-linear trench pattern can be formed based on a linear trench pattern, so that a non-linear trench structure can be etched on a substrate based on the non-linear trench pattern, which can increase a surface area of the trench structure without increasing an aspect ratio and maintaining the same footprint.

Optionally, before the etching the at least one trench structure 120, the method 200 further includes:
removing sharp corners at head and tail ends of the first pattern 121.

Specifically, sharp corners at head and tail ends of the first pattern 121 as shown in e in FIG. 6 are removed, as shown in f in FIG. 6.

For example, sharp corners less than 90 degrees at the head and tail ends of the first pattern 121 are removed.

It should be noted that by removing the sharp corners at the head and tail ends of the first pattern 121, when the first pattern 121 is used to produce a device (for example, an energy storage device), it is possible to avoid the formation of an area where an electric field is too concentrated at the sharp corners, thereby ensuring the performance of the produced device.

It should also be noted that the sharp corners at the head and tail ends of the first pattern 121 may be removed by cutting, erasing, or the like. Of course, the sharp corners at the head and tail ends of the first pattern 121 may also be removed in other ways, which is not limited in the present application.

In some possible implementation manners, the first dividing line 23 and/or the second dividing line 25 is at least one curve and/or at least one broken line.

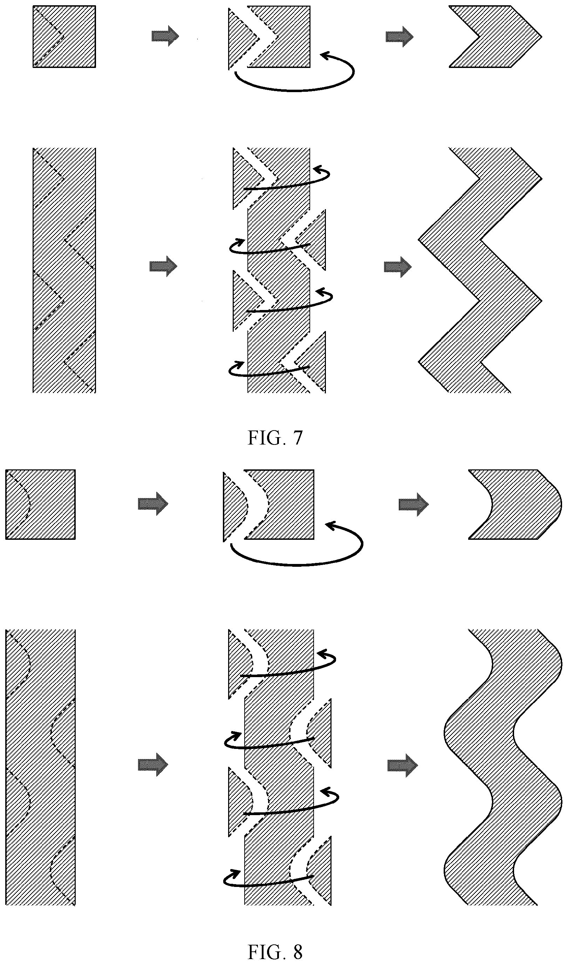

For example, as shown in FIG. 7, the first dividing line 23 and the second dividing line 25 are broken lines, and a non-linear trench pattern (a first pattern) shown in FIG. 7 is formed based on the above semiconductor structure production method 200.

For another example, as shown in FIG. 8, the first dividing line 23 and the second dividing line 25 are curves, and a non-linear trench pattern (a first pattern) shown in FIG. 8 is formed based on the above semiconductor structure production method 200.

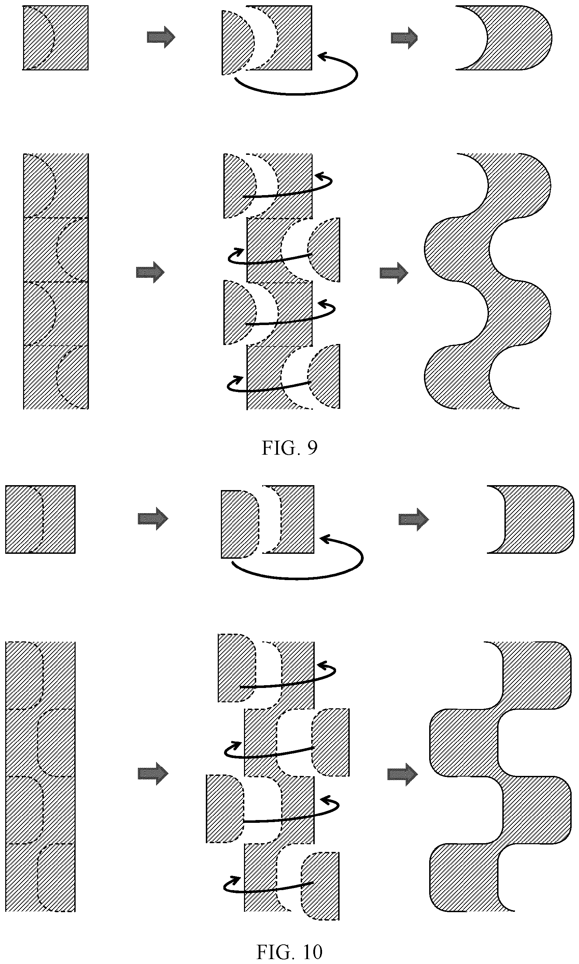

For another example, as shown in FIG. 9, the first dividing line 23 and the second dividing line 25 are also curves, and a non-linear trench pattern (a first pattern) shown in FIG. 9 is formed based on the above semiconductor structure production method 200.

For yet another example, as shown in FIG. 10, the first dividing line 23 and the second dividing line 25 are also curves, and a non-linear trench pattern (a first pattern) shown in FIG. 10 is formed based on the above semiconductor structure production method 200.

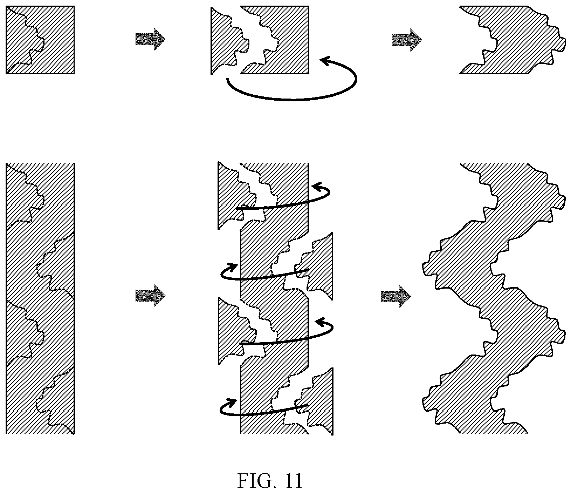

For yet another example, as shown in FIG. 11, the first dividing line 23 and the second dividing line 25 are also multiple broken lines, and a non-linear trench pattern (a first pattern) shown in FIG. 11 is formed based on the above semiconductor structure production method 200.

It should be noted that during the formation of the non-linear trench pattern shown in FIGS. 7 to 11, the first dividing line 23 and the second dividing line 25 are symmetrical with an axis of the linear trench pattern being a symmetry axis. The first basic pattern 24 is rotatable to obtain the second basic pattern 26, or the second basic pattern 26 is rotatable to obtain the first basic pattern 24. Of course, the first dividing line 23 and the second dividing line 25 may also be different. For example, the first dividing line 23 is a broken line, and the second dividing line 25 is a curve.

Therefore, in the embodiment of the present application, a non-linear trench pattern can be formed based on a linear trench pattern, so that a non-linear trench structure can be etched on a substrate based on the non-linear trench pattern, which can increase a surface area of the trench structure without increasing an aspect ratio and maintaining the same footprint.

Optionally, as an example, at least one insulating layer and at least one conductive layer may be alternately deposited in the at least one trench structure 120 to produce a capacitor.

For example, by means of thermal oxidation, silicon dioxide is deposited (grown) on the upper surface of the substrate 110 and the inner surface of the at least one trench structure 120 as the insulating layer. For another example, silicon dioxide or silicon nitride is grown by physical vapor deposition (Physical Vapor Deposition, PVD) or chemical vapor deposition (Chemical Vapor Deposition, CVD). For another example, a thin film of high dielectric constant material is grown by an atomic layer deposition (Atomic layer deposition, ALD) process, such as Al₂O₃, HfO₂, ZrO₂, TiO₂, Y₂O₃, La₂O₃, HfSiO₄, LaAlO₃, BaTiO₃, SrTiO₃, LaLuO₃, BST, PZT, and CCTO.

It should be noted that a material of the insulating layer includes a silicon oxide, a silicon nitride, a metal oxide, a metal nitride, or the like, such as silicon dioxide, silicon nitride, aluminum oxide, aluminum nitride, hafnium oxide, zirconium oxide, zinc oxide, titanium oxide, yttrium oxide, lanthanum oxide, hafnium silicate, lanthanum aluminate, lanthanum lutetium oxide, barium titanate, strontium titanate, barium strontium titanate, calcium copper titanate, lead zirconate titanate, etc. The insulating layer may be single-layered, or two or multi-layered. A specific material and a layer thickness may be adjusted according to a capacitance value, a frequency characteristic, a loss and other requirements of a capacitor.

For another example, a method of depositing the conductive layer includes ALD, PVD, metal-organic chemical vapor deposition, evaporation, electroplating, or the like. A conductive material of the conductive layer may be heavily doped polysilicon, a carbon-based material, or various metals such as aluminum, tungsten and copper, and may also be a low resistivity compound such as titanium nitride, or a combination of the above several conductive materials. The conductive layer may include at least one of: a heavily doped polysilicon layer, a carbon-based material layer, a metal layer, and a titanium nitride layer.

A person skilled in the art can understand that preferred embodiments of the present application are described in detail above with reference to the accompanying drawings. However, the present application is not limited to specific details in the foregoing embodiments. Within the technical concept of the present application, many simple variations may be made to the technical solution of the present application, and these simple variations are all within the scope of protection of the present application.

In addition, it should be noted that various specific technical features described in the foregoing specific embodiments may be combined in any suitable manner under the condition of no contradiction. In order to avoid unnecessary repetition, various possible combination ways will not be separately described in the present application.

In addition, any combination may be made between various embodiments of the present application without departing from the idea of the present application, and it should also be regarded as the disclosure of the present application.

## Claims

1. A semiconductor structure, comprising:
a substrate comprising an upper surface and a lower surface disposed opposite to each other; and
at least one trench structure disposed in the substrate and formed downward from the upper surface,
wherein a projection of the trench structure on the upper surface has a first pattern in a curved or broken line shape, and the first pattern comprises n second patterns adjacent to each other, and in the n second patterns, odd-numbered second patterns are the same, and even-numbered second patterns are the same, where n is a positive integer.

2. The semiconductor structure according to claim 1, wherein the odd-numbered second pattern is rotatable to obtain the even-numbered second pattern, or the even-numbered second pattern is rotatable to obtain the odd-numbered second pattern.

3. The semiconductor structure according to claim 1 or 2, wherein first patterns in different trench structures among the at least one trench structure are the same or different.

4. The semiconductor structure according to any one of claims 1 to 3, wherein the semiconductor structure is used to produce a structure with a high surface area and a low footprint.

5. The semiconductor structure according to any one of claims 1 to 4, wherein the semiconductor structure is used to produce an energy storage device and/or a sensor, wherein the energy storage device and/or the sensor comprises at least one conductive layer and at least one dielectric layer in the trench structure, and the at least one conductive layer and the at least one dielectric layer form a structure in which the conductive layer and the dielectric layer are adjacent to each other.

6. A semiconductor structure production method, comprising:
providing a substrate comprising an upper surface and a lower surface disposed opposite to each other; and
etching at least one trench structure on the substrate based on a first pattern in a curved or broken line shape, the trench structure entering the substrate downward from the upper surface, wherein the first pattern comprises n second patterns adjacent to each other, and in the n second patterns, odd-numbered second patterns are the same, and even-numbered second patterns are the same, where n is a positive integer.

7. The production method according to claim 6, wherein before the etching the at least one trench structure, the method further comprises:
providing a linear trench pattern with a length of L and a width of W, where L and W are positive numbers;
dividing the linear trench pattern into n rectangular patterns adjacent to each other, wherein the rectangular pattern has a first long side and a second long side with a length of L/n in a first direction, and the rectangular pattern has two wide sides with a width of W in a second direction, and the first direction is perpendicular to the second direction;
dividing an odd-numbered rectangular pattern in the n rectangular patterns into two first sub-patterns according to a first dividing line, wherein the two first sub-patterns include the first long side and the second long side respectively, and the first dividing line connects two end points of the first long side;
overlapping the long sides of the two first sub-patterns to form N1 first basic patterns, where N1 is a positive integer;
dividing an even-numbered rectangular pattern in the n rectangular patterns into two second sub-patterns according to a second dividing line, wherein the two second sub-patterns include the first long side and the second long side respectively, and the second dividing line connects two end points of the second long side;
overlapping the long sides of the two second sub-patterns to form N2 second basic patterns, where N2 is a positive integer; and
combining the N1 first basic patterns and the N2 second basic patterns to form the first pattern, where the sum of N1 and N2 is n.

8. The production method according to claim 7, wherein before the etching the at least one trench structure, the method further comprises:
removing sharp corners at head and tail ends of the first pattern.

9. The production method according to claim 8, wherein the removing the sharp corners at the head and tail ends of the first pattern comprises:
removing sharp corners less than 90 degrees at the head and tail ends of the first pattern.

10. The production method according to any one of claims 7 to 9, wherein the first dividing line and/or the second dividing line is at least one curve and/or at least one broken line.

11. The production method according to any one of claims 7 to 10, wherein the first dividing line and the second dividing line are symmetrical with an axis of the linear trench pattern being a symmetry axis.

12. The production method according to claim 11, wherein the first basic pattern is rotatable to obtain the second basic pattern, or the second basic pattern is rotatable to obtain the first basic pattern.

13. The production method according to any one of claims 6 to 12, wherein the etching the at least one trench structure on the substrate based on the first pattern in the curved or broken line shape comprises:
etching the at least one trench structure on the substrate by deep reactive ion etching based on the first pattern.
